Europäisches Patentamt

European Patent Office

Office européen des brevets

(19)

(11) **EP 0 854 354 B1**

(12) **EUROPÄISCHE PATENTSCHRIFT**

(45) Veröffentlichungstag und Bekanntmachung des Hinweises auf die Patenterteilung:
**07.05.2003 Patentblatt 2003/19**

(51) Int Cl.$^7$: **G01D 5/353**, G01R 15/24

(21) Anmeldenummer: **97810978.3**

(22) Anmeldetag: **12.12.1997**

(54) **Verfahren zur Temperaturkompensation von Messsignalen eines faseroptischen Sensors**

Method for temperature compensation of signals measured by a fiber optical sensor

Méthode pour compenser l'influence de la température sur les signaux mesurés par un capteur à fibre optique

(84) Benannte Vertragsstaaten:
**CH FR GB IT LI SE**

(30) Priorität: **16.01.1997 DE 19701221**

(43) Veröffentlichungstag der Anmeldung:
**22.07.1998 Patentblatt 1998/30**

(73) Patentinhaber: **ABB RESEARCH LTD.**
**8050 Zürich (CH)**

(72) Erfinder:
• **Bohnert, Klaus, Dr.**
**5443 Niederrohrdorf (CH)**
• **Péquignot, Pascal**
**5442 Fislisbach (CH)**

(74) Vertreter: **ABB Patent Attorneys**
**c/o ABB Schweiz AG**
**Brown Boveri Strasse 6**
**5400 Baden (CH)**

(56) Entgegenhaltungen:
**EP-A- 0 005 798**      **WO-A-95/10046**

• **BOHNERT K ET AL: "COHERENCE-TUNED INTERROGATION OF A REMOTE ELLIPTICAL-CORE, DUAL-MODE FIBER STRAIN SENSOR" JOURNAL OF LIGHTWAVE TECHNOLOGY, Bd. 13, Nr. 1, 1.Januar 1995, Seiten 94-103, XP000494977**
• **YOSHIDA K ET AL: "MICROWAVE CHARACTERISTICS OF A TRVELING-WAVE TYPE LINBO3 OPTICAL MODULATOR WITH SUPERCONDUCTING ELECTRODES" IEICE TRANSACTIONS ON ELECTRONICS, Bd. E76-C, Nr. 8, 1.August 1993, Seiten 1287-1290, XP000398159**

**Beschreibung**

TECHNISCHES GEBIET

Bei der Erfindung wird ausgegangen von einem Verfahren zur Temperaturkompensation von Meßsignalen eines faseroptischen Sensors nach dem Oberbegriff des Patentanspruchs 1.

STAND DER TECHNIK

Mit dem Oberbegriff des Patentanspruchs 1 nimmt die Erfindung auf einen Stand der Technik Bezug, wie er durch K. Bohnert et al., Coherence-Tuned Interrogation of a Remote Elliptical Core, Dual-Mode Fiber Strain Sensor, JOURNAL OF LIGHTWAVE TECHNOLOGY, Vol. 13, No. 1, January 1995, S. 94 - 103, bekannt ist. Dort werden 2 faseroptische Meßeinrichtungen zur Messung elektrischer Wechselspannungen beschrieben, bei denen die elektrische Spannung an einen zylinderförmigen Quarzkristall angelegt wird. Eine resultierende, periodische, piezoelektrische Deformation bzw. Umfangsänderung des Quarzkristalls wird auf eine 2Modenglasfaser als Sensorfaser übertragen. Die dadurch hervorgerufene periodische Dehnung der Sensorfaser führt zu einer Modulation des Phasenunterschiedes der beiden räumlichen, optischen Moden $LP_{01}$ und $LP_{11}$ (gerade), die sich in der Sensorfaser ausbreiten. Diese Phasenmodulation ist zur angelegten elektrischen Spannung proportional. Zur Messung wird Licht von einem Mehrmodenlaser über eine Einmodenfaser zur Sensorfaser, eine weitere Einmodenfaser und 2 Modulatoren mit einer 2Modenfaser als Empfangsfaser zu 2 Photodioden geleitet, welche das Interferenzmuster der beiden Moden detektieren. Die differentielle, optische Phase der Moden der Empfangsfaser wird mit Hilfe eines elektronischen Regelkreises und 2er piezoelektrischer Modulatoren derart geregelt, daß die Phasenmodulation in der Sensorfaser gerade wieder kompensiert wird. Die im Regelkreis erzeugte und an den Piezomodulatoren anliegende Regelspannung ist somit ein Abbild der zu messenden elektrischen Spannung. Statt in Transmission kann die Sensorfaser auch in Reflexion betrieben werden. Ein wesentliches Merkmal des Sensors besteht darin, daß Störungen durch Temperaturschwankungen und mechanische Erschütterungen, welche auf die Verbindungsfasern zwischen der Sende/Empfangseinheit und den Sensorkopf einwirken, das Meßsignal nicht beeinträchtigen. Längenänderungen von Sensor- und Empfangsfaser infolge von Temperaturänderungen führen ebenfalls zu optischen Phasenverschiebungen. Diese sind aber in der Regel so langsam, daß sie problemlos von den periodischen, elektrisch induzierten Phasenänderungen separiert werden können.

Der piezoelektrische Effekt in Quarz ist temperaturabhängig. Bei einer Temperaturerhöhung des Quarzes z. B. von 0 °C auf 100 °C nimmt das Sensorsignal um 2,15 % ab. Ohne Korrektur- oder Kompensationsmaßnahme führt diese Temperaturabhängigkeit zu einer Verfälschung des Meßsignals, wenn die Temperatur des Sensorelementes nicht konstant gehalten wird.

DARSTELLUNG DER ERFINDUNG

Die Erfindung, wie sie im Patentanspruch 1 definier ist, löst die Aufgabe, ein Verfahren zur Temperaturkompensation von Meßsignalen eines faseroptischen Sensors anzugeben.

Vorteilhafte Ausgestaltungen der Erfindung sind in den abhängigen Patentansprüchen definiert.

Ein Vorteil der Erfindung besteht darin, daß die Genauigkeit von Messungen mit einem faseroptischen Sensor verbessert werden kann, wenn dessen Temperatur nicht konstant gehalten wird.

Auf einen separaten Temperaturfühler am Sensorkopf kann verzichtet werden. Sensorkopf und elektronischer Teil des Sensors lassen sich somit galvanisch trennen.

Die Temperatur des Sensors wird aus dem Interferenzkontrast bestimmt. Temperaturänderungen ändern die Länge und optischen Parameter der Sensorfaser und damit den optischen Gangunterschied, den die beiden Moden in der Lichtfaser akkumulieren. Das wiederum hat eine Änderung des Interferenzkontrastes am Ende der Empfangsfaser zur Folge. Die Längen von Sensor- und Empfangsfaser werden so gewählt, daß sich ein eindeutiger Zusammenhang zwischen Kontrast und Temperatur ergibt.

Zur Messung des Interferenzkontrastes wird in den Piezomodulator des Regelkreises ein zusätzliches Wechselsignal konstanter Amplitude eingespeist, dessen Frequenz oberhalb der Bandbreite des Regelkreises liegt. Die resultierende Modulation des Phasenunterschiedes der beiden Moden wird dann vom Regelkreis nicht kompensiert. Die Amplitude der entsprechenden Modulation der Lichtintensität an den beiden Photodioden ist zum Interferenzkontrast proportional. Um etwaige Schwankungen des Gleichanteils der Lichtintensität auszugleichen, wird das Wechselsignal auf den Gleichanteil der Lichtintensität an den beiden Photodioden normiert.

KURZE BESCHREIBUNG DER ZEICHNUNGEN

Die Erfindung wird nachstehend anhand eines Ausführungsbeispiels erläutert. Es zeigen:

| | |
|---|---|
| Fig. 1 | schematisch eine faseroptische Meßeinrichtung mit einer 2Moden-Sensorfaser in Transmissionsanordnung, |
| Fig. 2 und 3 | anregbare optische Moden einer Sensorfaser und einer Zuleitungsfaser gemäß Fig. 1, |
| Fig. 4 | eine Kalibrierkurve für eine vorgebbare |

Fig. 5

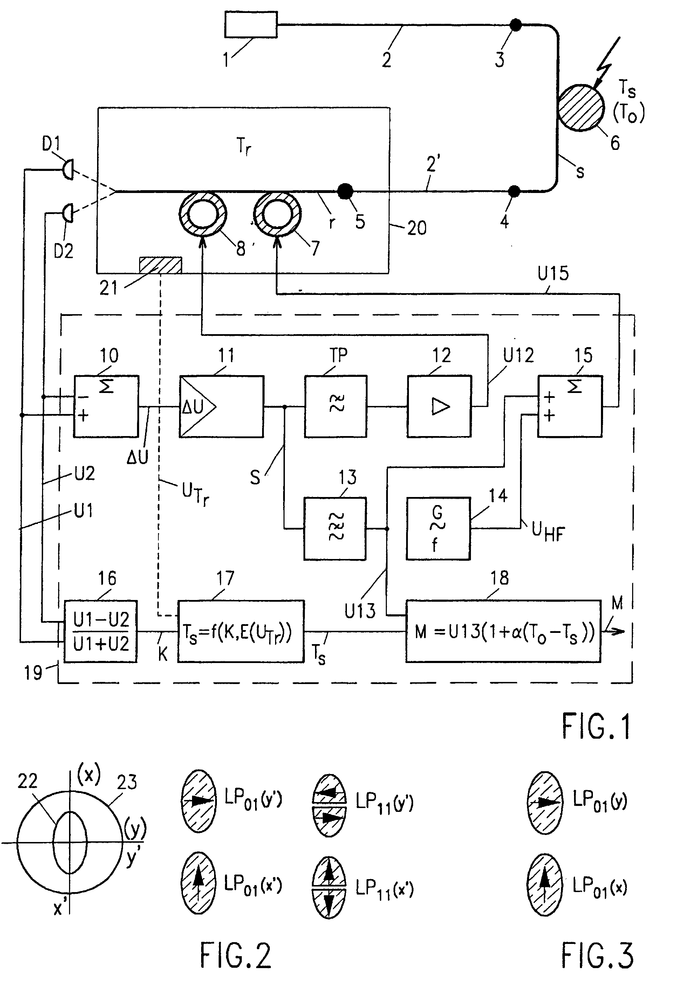

Temperatur eines Signalempfängers der Meßeinrichtung gemäß Fig. 1 in Abhängigkeit von der Differenz der akkumulierten Gangunterschiede in der Sensorfaser und einer Empfangsfaser und eine Kalibrierkurve für eine vorgebbare Temperatur des Signalempfängers der Meßeinrichtung gemäß Fig. 1 in Abhängigkeit von der Temperatur der Sensorfaser.

WEGE ZUR AUSFÜHRUNG DER ERFINDUNG

In den Figuren sind gleiche Teile mit gleichen Bezugszeichen gekennzeichnet.

Fig. 1 zeigt schematisch eine faseroptische Meßeinrichtung mit einem Quarzzylinder bzw. einem piezoelektrischen Sensorelement (6) aus Quarz mit einer auf dessen Zylinderumfang gewickelten 2Moden-Glasfaser bzw. Lichtfaser bzw. Sensorfaser (s) in einer Transmissionsanordnung. Die verwendete 2Moden-Sensorfaser (s) weist einen elliptischen Faserkern (22) mit zueinander orthogonalen optischen Hauptachsen (x', y') auf. Der Faserkern (22) ist von einem Fasermantel (23) umgeben, vgl. Fig. 2 links. Bei einer vorgegebenen Wellenlänge sind ein $LP_{01}$-Grundmodus und ein gerader $LP_{11}$-Modus ausbreitungsfähig. Diese Moden werden mit einer Polarisation parallel zur großen Hauptachse (x') oder parallel zur kleinen Hauptachse (y') angeregt. Die angeregten Moden sind entsprechend mit $(LP_{01}(x'))$, $(LP_{11}(x'))$ bzw. $(LP_{01}(y'))$ und $(LP_{11}(y'))$ bezeichnet, vgl. Fig. 2 Mitte und rechts.

Von einer niederkohärenten Lichtquelle (1), z. B. einer Mehrmoden-Laserdiode, wird Licht über eine hochdoppelbrechende und damit polarisationserhaltende Einmodenglasfaser bzw. Einmodenlichtfaser bzw. Zuleitungsfaser (2) mit 2 zueinander orthogonalen optischen Hauptachsen (x, y), deren Orientierung in Fig. 2 in Klammern angegeben ist, der Sensorfaser (s) über eine Glasfaserverbindung bzw. einen Spleiß (3) zugeführt. In der Einmodenlichtfaser (2) ist das Licht parallel zu einer der optischen Hauptachsen (x, y) des elliptischen Faserkerns (22) polarisiert. Die Zuleitungsfaser (2) und die Sensorfaser (s) sind in dem Spleiß (3) so zusammengespleißt, daß ihre optischen Hauptachsen (x, y; x', y') in einem Winkel von 0° oder 90° zueinander stehen. Die optischen Hauptachsen (x, y; x', y') dieser beiden verspleißten Fasern (2, s) dürfen allenfalls um einen tolerierbaren Differenzwinkel ($\varepsilon$) von $\leq 30°$, vorzugsweise von $\leq 10°$ von diesem Winkel abweichen.

Je nach Polarisationsrichtung des Lichtes in der Zuleitungsfaser (2) und dem Winkel zwischen den optischen Hauptachsen (x, y; x', y') im Spleiß (3) werden die Moden ($LP_{01}$) und ($LP_{11}$) der Sensorfaser (s) entweder mit der Polarisation parallel zu (x') oder (y') angeregt. Die beiden Fasern (2, s) sind ferner mit einem lateralen Versatz der Faserkerne (22) parallel zur großen Hauptachse (x') des Faserkerns (22) der Sensorfaser (s) zusammengespleißt. Der Versatz ist derart, daß die beiden Moden ($LP_{01}$) und ($LP_{11}$) der Sensorfaser (s) mit etwa gleicher Amplitude angeregt werden.

Die Sensorfaser (s) steht mit einem piezoelektrischen Sensorelement (6), z. B. einem Quarzzylinder, in Wirkverbindung, auf den ein bezüglich seiner Amplitude zu messendes elektrisches Feld einwirkt, welches durch ein Blitzzeichen angedeutet ist.

Nach einem Durchlaufen der Sensorfaser (s) wird das Licht über einen Spleiß (4) in eine weitere polarisationserhaltende Einmodenlichtfaser bzw. Rückleitungsfaser (2') und von dieser über einen weiteren Spleiß (5) in eine optische 2Modenlichtfaser bzw. Empfangsfaser (r) eingekoppelt.

Für die Orientierung der optischen Hauptachsen im Spleiß (4) gilt dasselbe wie im Spleiß (3). Ebenso sind die Fasern (s, 2') mit einem lateralen Versatz der Faserkerne (22) zusammengespleißt, derart, daß die beiden Moden ($LP_{01}$) und ($LP_{11}$) der Sensorfaser (s) zu gleichen Anteilen in die Rückleitungsfaser (2') eingekoppelt werden. Der Spleiß (5) ist wie der Spleiß (3) ausgeführt.

Die Empfangsfaser (r) ist um 1. und 2. Hohlzylinder aus einer piezoelektrischen Keramik bzw. um piezoelektrische Modulatoren (7, 8) gewickelt; sie steht ausgangsseitig mit 2 optoelektrischen Detektoren bzw. Photodioden bzw. Lichtdetektoren (D1, D2) in optischer Verbindung, welche jeweils ausgangsseitig eine Ausgangsspannung (U1) bzw. (U2) liefern, die zur empfangenen Lichtleistung proportional ist. Die Lichtdetektoren (D1, D2) sind so angeordnet, daß sie beide jeweils eine der beiden gegenphasigen Substrukturen des Interferenzmusters detektieren.

Die beiden räumlichen Moden ($LP_{01}$) und ($LP_{11}$) der Sensorfaser (s) akkumulieren einen Gangunterschied $\Delta L_s = l_s \cdot \Delta n_{g,s}$, wobei $l_s$ die Länge der Sensorfaser (s) und $\Delta n_{g,s}$ der Unterschied der Gruppenbrechungsindizes der beiden Moden ist.

Die beiden räumlichen Moden der Empfangsfaser (r), je nach der Orientierung der Sensorfaser (s) im Spleiß (5) und der Polarisationsrichtung in der Rückleitungsfaser (2') sind dies entweder der $LP_{01}(x')$- und der gerade $LP_{11}(x')$-Modus oder der $LP_{01}(y')$- und der gerade $LP_{11}(y')$-Modus, akkumulieren einen Gangunterschied:

$$\Delta L_r = l_r \cdot \Delta n_{g,r},$$

wobei $l_r$ die Länge der Empfangsfaser (r) und $\Delta n_{g,r}$ der Unterschied der Gruppenbrechungsindizes der beiden Moden ist. Die Faserlängen $l_s$ und $l_r$ werden so gewählt, daß $\Delta L_s$ und $\Delta L_r$ innerhalb der Kohärenzlänge der Lichtquelle (1) gleich sind.

Am Ende der Empfangsfaser (r) gibt es Lichtwellen mit einem relativen Gangunterschied von $\Delta L_r - \Delta L_s \approx 0$, die miteinander kohärent interferieren und Lichtwellen mit relativen Gangunterschieden von $\Delta L_s$

und $\Delta L_r$ (mit $\Delta L_s \approx \Delta L_r$) sowie $\Delta L_s + \Delta L_r$, welche inkohärent interferieren und lediglich einen konstanten Untergrund zum Interferenzmuster liefern. Wichtig ist, daß $\Delta L_s$ bzw. $\Delta L_r$ deutlich größer als die Kohärenzlänge der Lichtquelle (1) sind.

In einer Sensorfaser (s) bzw. einer Empfangsfaser (r) mit einer nominalen Länge der großen Hauptachse des Faserkerns (22) von 4 µm, einer Länge der kleinen Hauptachse von 2 µm, einem nominalen Brechungsunterschied zwischen Faserkern (22) und Fasermantel (23) von 0,03 und einer Faserlänge von 1 m wurde für die beiden räumlichen Moden ein akkumulierter optischer Wegunterschied von etwa 3,3 mm bei einer Wellenlänge von 780 nm gemessen. Der Unterschied zwischen den Gruppenbrechungsindizes der beiden Moden ($LP_{01}$) und ($LP_{11}$) der Sensorfaser (s) und der Empfangsfaser (r) ist abhängig von der Wellenlänge. Insbesondere gibt es eine Wellenlänge, bei der $\Delta n_{g,s}$ und $\Delta n_{g,r}$ gleich 0 wird. Der Gruppenbrechungsindexunterschied zeigt gewöhnlich eine schwache Abhängigkeit von der Polarisationsrichtung des Lichtes. Dieser Effekt ist typisch kleiner als 2 %.

Die Empfindlichkeit der Fasern, d. h. die differentielle Phasenänderung bei einer gegebenen Längenänderung der Faser, ist abhängig vom Unterschied der Brechungsindizes von Faserkern (22) und Fasermantel (23), der Kerngröße und -Form sowie der Wellenlänge. Für Fasern mit einem elliptischen Faserkern (14) des oben genannten Typs ist für eine Phasenverschiebung von $2\pi$ zwischen den räumlichen Moden ($LP_{01}$) und ($LP_{11}$) bei einer Wellenlänge von 780 nm eine Längenänderung von ca. 100 µm erforderlich.

Ein Differenzbildner (10), dem eingangsseitig die Ausgangsspannungen (U1) und (U2) der Lichtdetektoren (D1, D2) zugeführt sind, liefert ausgangsseitig eine Differenzspannung ($\Delta U$) an einen Regler bzw. Differenzspannungsregler (11), welcher die Differenzspannung ($\Delta U$) auf 0 regelt. Dieser Differenzspannungsregler (11) liefert ausgangsseitig ein Signal (S), das sowohl einen Gleich- als auch einen Wechselspannungsanteil enthält. Dieses Signal (S) gelangt über ein Tiefpaßfilter (TP) an einen Gleichspannungsverstärker (12), welcher ausgangsseitig eine Kompensationsspannung (U12) an einen Modulator (8) überträgt. Das Signal (S) ist ferner einem Sperrfilter (13) für die Resonanzfrequenz eines Modulators (7) zugeführt, welches ausgangsseitig eine Kompensationsspannung (U13) über einen Summierer (15) an den Modulator (7) überträgt. Das Sperrfilter (13) hat die Aufgabe, ein Schwingen des Regelkreises auf der Resonanzfrequenz des Modulators (7) zu verhindern. Die Kompensationsspannung (U13) ist proportional zu der zu messenden elektrischen Wechselspannung, jedoch nicht temperaturkompensiert und somit ggf. fehlerhaft.

Die durch eine gegebene, am Sensor (6) anliegende Spannung hervorgerufene optische Phasenverschiebung ist abhängig von der Temperatur des Sensorelementes (6), von dessen Geometrie, vom Typ der Sensorfaser (s) und der Länge des mit dem Sensor (6) in Verbindung stehenden Lichtfasersegments. Die Kompensationsspannung (U13) zur Kompensation einer gegebenen Phasenverschiebung ist abhängig von der Geometrie und vom Material des Modulators (7), vom Typ der Empfangsfaser (r), von der Länge des mit dem Modulator (7) in Verbindung stehenden Lichtfasersegments und von einer Signalempfängertemperatur ($T_r$), die gleich der Temperatur des Modulators (7) ist. Der Modulator (7) kann z. B. so ausgelegt sein, daß eine Kompensationsspannung (U13) von $\pm 3$ V eine differentielle optische Phasenverschiebung von $\pm 10°$ zwischen den Moden ($LP_{01}$) und ($LP_{11}$) der Empfangsfaser (r) bewirkt. Die Temperaturabhängigkeit des inversen piezoelektrischen Effektes des Sensors (6) äußert sich bei gegebener, am Sensor (6) anliegender Spannung als entsprechende Änderung der zur Kompensation erforderlichen Kompensationsspannung (U13) mit der Temperatur.

Zur Kompensation der Temperaturabhängigkeit wird der Kompensationsspannung (U13) in dem Summierer (15) ein Oszillatorsignal ($U_{HF}$) konstanter Amplitude vom Ausgang eines Hochfrequenzoszillators (14) überlagert, dessen Frequenz (f) oberhalb der Bandbreite des Regelkreises des Differenzspannungsreglers (11), vorzugsweise im Frequenzbereich zwischen 50 kHz und 1 MHz, liegt. Das Oszillatorsignal ($U_{HF}$) wird dann vom Regelkreis des Differenzspannungsreglers (11) nicht kompensiert.

Die Amplitude der resultierenden Modulation der Lichtintensität an den beiden Lichtdetektoren (D1, D2) ist zu einem Interferenzkontrast

$$V = (U1_{max} - U2_{min})/(U1_{max} + U2_{min})$$

proportional, wobei $U1_{max}$ und $U2_{min}$ die Intensitäten der Maxima und Minima eines Interferenzstreifenmusters sind.

Um ein Signal zu erhalten, das unabhängig von Schwankungen der optischen Leistung des Mehrmodenlasers (1) ist, wird ein Kontrastparameter

$$K = (U1 - U2)/(U1 + U2)$$

in einem Quotientenbildner (16) gebildet. Der Kontrastparameter (K) unterscheidet sich von dem Interferenzkontrast (V) nur durch einen konstanten Faktor. Dem Quotientenbildner (16) sind eingangsseitig die Ausgangsspannungen (U1) und (U2) der Lichtdetektoren (D1, D2) zugeführt, welche spektrale Komponenten mit der Frequenz (f) des Hochfrequenzoszillators (14) enthalten.

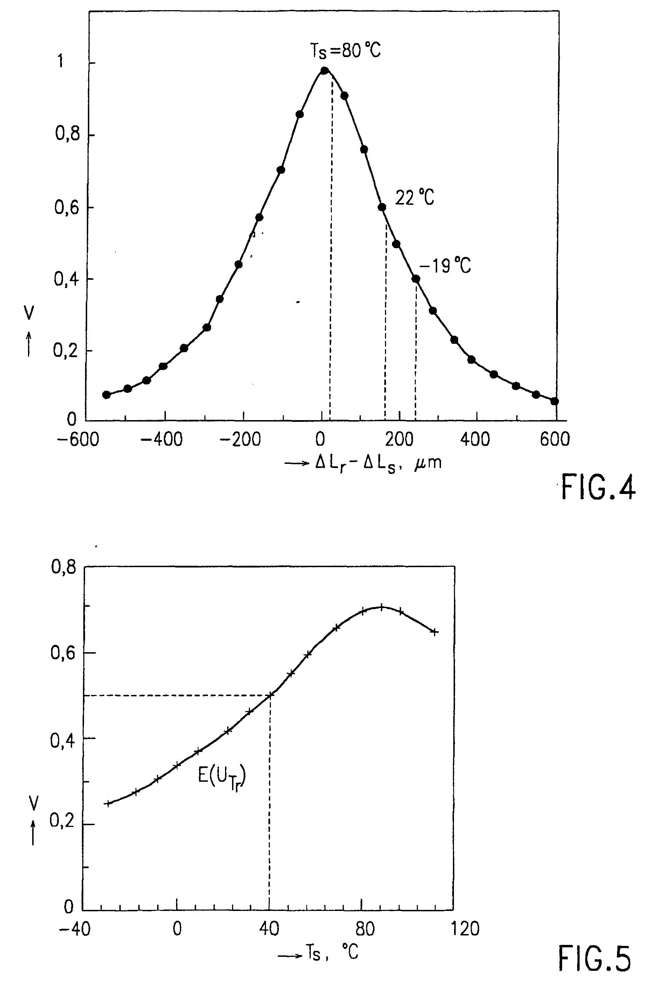

In Abhängigkeit von der Sensortemperatur ($T_s$) verändert sich ein relativer Gangunterschied $\Delta L_r - \Delta L_s$, der in Fig. 4 auf der Abszisse in µm angegeben ist, und somit auch der Interferenzkontrast (V), der auf der Ordinate angegeben ist. Aus der Kurve in Fig. 4 kann eine Kalibrierkurve (E) abgeleitet werden, vgl. Fig. 5, die den Zusammenhang zwischen der Sensortemperatur ($T_s$) und dem Interferenzkontrast (V) angibt. Die Daten in Fig. 4 und 5 wurden bei einer konstanten Signalempfängertemperatur ($T_r$) von 22 °C gemessen. Wenn die Signalempfängertemperatur ($T_r$) nicht konstant gehalten wird, sondern sich ändert, dann ändert sich auch ein optisch akkumulierter Gangunterschied $\Delta L_r$ der Empfangsfaser (r) und damit die Kalibrierkurve (E). Dies wird berücksichtigt, indem die Signalempfängertemperatur ($T_r$) von einem temperaturabhängigen Widerstand bzw. Temperaturdetektor (21), der an einem optischen Signalempfänger (20) angebracht ist, welcher die Modulatoren (7, 8), die Empfangsfaser (r) und den Spleiß (5) umfaßt, gemessen wird. Der Temperaturdetektor (21) liefert ein zu einer Signalempfängertemperatur ($T_r$) proportionales Signalempfänger-Temperatursignal ($U_{Tr}$), das zusammen mit dem Kontrastparameter (K) des Quotientenbildners (16) an einen Funktionsbildner (17) geliefert wird. Dieser berechnet in Abhängigkeit von dem Kontrastparameter (K) und dem Signalempfänger-Temperatursignal ($U_{Tr}$) die Sensortemperatur ($T_s$) der Sensorfaser (s) gemäß:

$$T_s = f(K, E(U_{Tr})).$$

Bei einem Interferenzkontrast (V) von z. B. 0,5 beträgt die Sensortemperatur ($T_s$) 40 °C für $T_r$ = 22 °C.

Der Betrag, um den sich der relative Gangunterschied $\Delta L_r - \Delta L_s$ und folglich der Interferenzkontrast (V) in einem gegebenen Temperaturintervall ändern, läßt sich über die Länge der Lichtfasern und die Wahl ihrer optischen Parameter beeinflussen. Die Stärke der Kontraständerung kann außerdem über die Wahl der Lichtquelle beeinflußt werden. Je niederkohärenter die Lichtquelle (1) ist, desto schmäler ist die Kurve in Fig. 4 und umso höher die Kontraständerung in einem gegebenen Temperaturintervall. Besonders niederkohärente Lichtquellen (1), die gut an Monomode-Lichtfasern angekoppelt werden können, sind sog. Superlumineszenzdioden und unter dem Schwellstrom betriebene Laserdioden. Es ist jedoch darauf zu achten, daß der Interferenzkontrast (V) im gesamten Temperaturbereich ausreichend groß, vorzugsweise > 0,2, bleibt, um für alle Betriebstemperaturen eine ausreichende Sensorgenauigkeit zu gewährleisten.

Die Bedingung einer konstanten Signalempfängertemperatur ($T_r$) läßt sich in der Praxis relativ einfach erfüllen, da diese Empfangsfaser (r) ein Teil des Signalempfängers (20) ist.

Die ausgangsseitig am Funktionsbildner (17) abgreifbare Sensortemperatur ($T_s$) wird zusammen mit der Kompensationsspannung (U13) einem weiteren Funktionsbildner (18) zugeführt, der ausgangsseitig ein temperaturkorrigiertes Meßsignal (M) gemäß:

$$M = U13 \cdot (1 + \alpha \cdot (T_0 - T_s))$$

liefert, wobei $T_0$ eine Kalibrierungstemperatur der Sensorfaser (s), z. B. 22 °C, und $\alpha$ den Temperaturkoeffizienten des Sensorelementes (6) bedeuten. Für ein Sensorelement (6) aus Quarz ist $\alpha$ = - 2,15 · 10$^{-4}$ K$^{-1}$.

Es versteht sich, daß die Signalempfängertemperatur ($T_r$) nicht erfaßt werden muß, wenn sie bekannt ist und konstant gehalten wird.

Die Funktionen des Tiefpaßfilters (TP) und der Geräte (10) - (18) können mittels eines Rechners bzw. Mikroprozessors (19) ausgeführt werden. Dabei ist eingangsseitig ein Analog/Digitalwandler und ausgangsseitig ein Digital/Analogwandler vorzusehen (nicht dargestellt). Damit läßt sich durch einen Programmaustausch im Mikroprozessor (19) die erfindungsgemäße Temperaturkompensation leicht bei bestehenden Meßeinrichtungen mit faseroptischen Sensoren realisieren.

Anstelle der 2Moden-Sensorfaser (s) kann grundsätzlich auch eine polarimetrische Lichtfaser verwendet werden. Eine polarimetrische Lichtfaser weist 2 zueinander orthogonale optische Hauptachsen (x', y') senkrecht zur Faserrichtung auf. Bei einer vorgegebenen Wellenlänge sind die beiden orthogonalen Polarisationszustände ($LP_{01}(x')$) und ($LP_{01}(y')$) des $LP_{01}$-Grundmodus ausbreitungsfähig mit Polarisationen parallel zu den optischen Hauptachsen (x', y'). Die effektiven Brechungsindizes für die beiden Polarisationen sind unterschiedlich, d. h., die Lichtfaser ist doppelbrechend.

Die beiden orthogonalen Polarisationszustände ($LP_{01}(x')$) und ($LP_{01}(y')$) der Sensorfaser (s) akkumulieren einen Gangunterschied $\Delta L_s = l_s \cdot \Delta n_{g,s}$, wobei $l_s$ die Länge der Sensorfaser (s) und $\Delta n_{g,s}$ der Unterschied der Gruppenbrechungsindizes der orthogonalen Polarisationszustände ($LP_{01}(x')$) und ($LP_{01}(y')$) der Sensorfaser (s) ist. Die Faserlängen $l_s$ und $l_r$ der Sensorfaser (s) bzw. der Empfangsfaser (r) sind wiederum so gewählt, daß $\Delta L_s$ und $\Delta L_r$ innerhalb der Kohärenzlänge des Mehrmodenlasers (1) gleich sind.

Die optischen Hauptachsen (x', y') der Sensorfaser (s) bilden in den Spleißen (3) und (4) mit den optischen Hauptachsen (x, y) der Zu- bzw. Rückleitungsfasern (2, 2') einen Winkel von 45° ± ε.

In einer weiteren möglichen Konfiguration sind sowohl die Sensor- als auch die Empfangsfaser (s, r) polarimetrische Fasern. In diesem Fall bilden in allen Spleißen (3 - 5) die optischen Hauptachsen (x, y; x', y') der Fasern einen Winkel von 45° ± ε. Am Ende der Empfangsfaser (r) werden die beiden orthogonalen Polarisationszustände der Empfangsfaser (r) z. B. mit Hilfe eines Wollaston-Prismas (nicht dargestellt) zur Interferenz gebracht und die beiden resultierenden Signale den Lichtdetektoren (D1, D2) zugeführt.

Es versteht sich weiterhin, daß anstelle von Quarzzylindern und Piezokeramiken auch andere piezoelektrische Bauelemente als Sensorelement (6) und als Modulatoren (7, 8, 22, 22') verwendet werden können.

Prinzipiell können die Zuleitungsfaser (2) und die Rückleitungsfaser (2') entfallen. Das polarisierte Licht könnte z. B. durch die Luft oder durch Vakuum übertragen und mit Hilfe von Linsen in die Lichtfasern eingekoppelt werden.

Der Beitrag der Sensorfaser (s) zur Temperaturabhängigkeit der Kompensationsspannung (U13) ist bei Verwendung eines geeigneten Fasermantels (23), z. B. aus einem dünnen Polyamid, vernachlässigbar.

Anstatt der elektrischen Spannung kann auch eine andere physikalische Größe gemessen werden, sofern sie eine Längenänderung der Sensorfaser (s) bewirkt, die eindeutig dieser physikalischen Größe zugeordnet werden kann.

BEZEICHNUNGSLISTE

| | |
|---|---|
| 1 | Lichtquelle, Mehrmodenlaser |
| 2 | Einmodenlichtfaser, hochdoppelbrechende Einmodenglasfaser, Zuleitungsfaser |
| 2' | Einmodenlichtfaser, hochdoppelbrechende Einmodenglasfaser, Rückleitungsfaser |
| 3 - 5 | Spleiße, Glasfaserverbindungen |
| 6 | Sensorelement, Quarzzylinder, Sensor |
| 7, 8 | Modulatoren |
| 9 | Analysator |
| 10 | Differenzbildner |
| 11 | Regler, Differenzspannungsregler |
| 12 | Gleichspannungsverstärker |
| 13 | Sperrfilter |
| 14 | Hochfrequenzoszillator |
| 15 | Summierer |
| 16 | Quotientenbildner |
| 17 | Funktionsbildner für $T_s$ |
| 18 | Funktionsbildner für M |
| 19 | Mikroprozessor, Rechner |
| 20 | optischer Signalempfänger |
| 21 | Temperaturdetektor, temperaturabhängiger Widerstand |
| 22 | Faserkern |
| 23 | Fasermantel |
| | |
| D1, D2 | Lichtdetektoren, optoelektrische Detektoren, Photodioden |
| E | Kalibrierkurve, Temperatur-Kalibrierkurve, Temperatur-Kalibrierfunktion |
| f | Frequenz von 14 |
| K | Kontrastparameter |
| M | temperaturkorrigiertes Meßsignal |
| $LP_{01}$ | optischer Grundmodus |
| $LP_{11}$ | optischer gerader Modus |
| P | Lichtleistung von 1 |
| r | optische 2Modenlichtfaser, polarimetri- |

| | |
|---|---|
| | sche Lichtfaser, Empfangsfaser |
| s | polarimetrische optische Faser, Sensorfaser, 2Modenlichtfaser |
| S | Signal am Ausgang von 11 |
| TP | Tiefpaßfilter |
| $T_s$ | Sensortemperatur |
| $T_r$ | Signalempfängertemperatur |
| $T_0$ | Kalibrierungstemperatur von s |
| U1, U2 | Ausgangsspannungen von D1, D2, Lichtleistungssignale |
| U12 | Ausgangssignal von 12, Kompensationsspannung, Kompensationspotential |
| U13 | Ausgangssignal von 13, Kompensationsspannung, Kompensationspotential, Regelsignal |
| U15 | Ausgangssignal von 15, Kompensationsspannung |
| $U_{HF}$ | Oszillatorsignal |
| $U_{Tr}$ | Temperatursignal von 21 |
| V | Interferenzkontrast |
| x, y; x', y' | optische Hauptachsen |
| $\alpha$ | Temperaturkoeffizient von 6 |
| $\Delta L_s$ | akkumulierter optischer Gangunterschied in s |
| $\Delta L_r$ | akkumulierter optischer Gangunterschied in r |
| $\Delta U$ | Differenzspannung |
| $\varepsilon$ | Differenzwinkel, Toleranzwinkel |

**Patentansprüche**

1. Verfahren zur Temperaturkompensation von Meßsignalen eines faseroptischen Sensors (6),

   a) bei dem Licht durch eine optische Sensorfaser (s) zur Erfassung einer physikalischen Größe zu einer optischen Empfangsfaser (r) geleitet wird,

   b) wobei sich das Licht in der Sensorfaser (s) und in der Empfangsfaser (r) in zwei verschiedenen räumlichen Moden oder in zwei orthogonalen Polarisationszuständen eines räumlichen Modus ausbreitet,

   c) wobei am Ende der Empfangsfaser (r) ein Interferenzmuster der räumlichen Moden oder der orthogonalen Polarisationszustände mit zwei Lichtdetektoren (D1, D2) detektiert wird, die ausgangsseitig zur empfangenen Lichtleistung proportionale erste und zweite Lichtleistungssignale U1, U2 liefern,

   d) deren Differenz ($\Delta U$) an den Eingang eines Differenzspannungsreglers (11) geliefert wird, welcher ausgangsseitig ein Regelsignal U13 liefert,

   e) das auf einen Modulator (7) wirkt, der mit der Empfangsfaser (r) in Wirkverbindung steht, und die differentielle optische Phase der räumlichen Moden oder der orthogonalen Polarisationszustände der Empfangsfaser (r) derart regelt, daß diese Differenz (ΔU) gleich 0 wird, **dadurch gekennzeichnet**

f) daß dem Regelsignal (U13) ein Oszillatorsignal ($U_{HF}$) mit vorgebbarer Amplitude überlagert wird, dessen Frequenz (f) mindestens so groß ist, daß eine durch das Oszillatorsignal ($U_{HF}$) bewirkte Lichtmodulation mit der Frequenz (f) in der Empfangsfaser (r) durch den Differenzspannungsregler (11) nicht kompensiert wird,

g) daß in Abhängigkeit von diesen ersten und zweiten Lichtleistungssignalen (U1, U2) ein Kontrastparameter K berechnet wird gemäß:

$$K = (U1 - U2)/(U1 + U2),$$

h) daß eine Signalempfängertemperatur $T_r$ mit einem Temperaturdetektor (21) gemessen wird,

i) daß in Abhängigkeit von diesem Kontrastparameter (K) und einer Temperatur-Kalibrierfunktion $E(T_r)$ eine Sensortemperatur $T_s$ gemäß: $T_s = f(K, E(T_r))$ bestimmt wird und

j) daß in Abhängigkeit von dieser Sensortemperatur ($T_s$) und dem Regelsignal (U13) ein temperaturkorrigiertes Meßsignal M gemäß:

$$M = U13 \cdot (1 + \alpha \cdot (T_0 - T_s))$$

bereitgestellt wird, wobei $T_0$ eine vorgebbare Kalibrierungstemperatur der Sensorfaser (s) und α den Temperaturkoeffizienten des Sensors (6) bedeuten.

2. Verfahren nach Anspruch 1, **dadurch gekennzeichnet**,

   a) daß die Amplitude des Oszillatorsignals ($U_{HF}$) konstant gehalten wird und
   b) daß die Frequenz (f) des Oszillatorsignals ($U_{HF}$) im Frequenzbereich von 50 kHz - 1 MHz liegt.

3. Verfahren nach Anspruch 1 oder 2, **dadurch gekennzeichnet, daß** die Signalempfängertemperatur ($T_r$) auf einem vorgebbaren Temperaturwert konstant gehalten wird.

4. Verfahren nach einem der vorhergehenden Ansprüche, **dadurch gekennzeichnet**,

   a) daß die Sensorfaser (s) eine Zweimodenfaser ist, in der sich ein $LP_{01}$-Grundmodus und ein gerader $LP_{11}$-Modus ausbreiten, und

b) daß die Empfangsfaser (r) eine Zweimodenfaser ist, in der sich der $LP_{01}$-Grundmodus und der gerade $LP_{11}$-Modus ausbreiten.

5. Verfahren nach einem der Ansprüche 1 bis 3, **dadurch gekennzeichnet**,

   a) daß die Sensorfaser (s) eine polarimetrische Faser ist, in der sich die beiden orthogonalen Polarisationszustände eines $LP_{01}$-Grundmodus ausbreiten, und
   b) daß die Empfangsfaser (r) eine Zweimodenfaser ist, in der sich der $LP_{01}$-Grundmodus und ein gerader $LP_{11}$-Modus ausbreiten.

6. Verfahren nach einem der Ansprüche 1 bis 3, **dadurch gekennzeichnet**,

   a) daß die Sensorfaser (s) eine polarimetrische Faser ist, in der sich die beiden orthogonalen Polarisationszustände eines $LP_{01}$-Grundmodus ausbreiten, und
   b) daß die Empfangsfaser (r) eine polarimetrische Faser ist, in der sich die beiden orthogonalen Polarisationszustände des $LP_{01}$-Grundmodus ausbreiten.

7. Verfahren nach einem der vorhergehenden Ansprüche, **dadurch gekennzeichnet**,

   a) daß der Kontrastparameter (K) in Abhängigkeit von der Sensortemperatur ($T_s$) und
   b) in Abhängigkeit von einem akkumulierten, relativen optischen Gangunterschied

$$\Delta L_r - \Delta L_s$$

ermittelt wird, mit

$$\Delta L_r = l_r \cdot \Delta n_{g,r},$$

wobei $l_r$ die Länge der Empfangsfaser (r) und $\Delta n_{g,r}$ der Unterschied der Gruppenbrechungsindizes der beiden Moden sind, entweder der $LP_{01}(x')$- und der gerade $LP_{11}(x')$-Modus oder der $LP_{01}(y')$- und der gerade $LP_{11}(y')$-Modus, im Falle einer Zweimodenfaser, je nach Polarisation in Richtung von deren optischen Hauptachsen (x', y') bzw. der $LP_{01}(x')$- und der $LP_{01}(y')$-Modus, im Falle einer polarimetrischen Faser, und mit

$$\Delta L_s = l_s \cdot \Delta n_{g,s},$$

wobei $l_s$ die Länge der Sensorfaser (s) und

$\Delta n_{g,s}$ der Unterschied der Gruppenbrechungsindizes der beiden Moden sind,
entweder der $LP_{01}(x')$- und der gerade $LP_{11}(x')$-Modus oder der $LP_{01}(y')$- und der gerade $LP_{11}(y')$-Modus, im Falle einer Zweimodenfaser, je nach Polarisation in Richtung einer der optischen Hauptachsen (x', y') bzw. der $LP_{01}(x')$- und der $LP_{01}(y')$-Modus, im Falle einer polarimetrischen Faser.

**8.** Verfahren nach Anspruch 7, **dadurch gekennzeichnet, daß** der Kontrastparameter (K) zusätzlich in Abhängigkeit von der Signalempfängertemperatur $(T_r)$ ermittelt wird.

**Claims**

**1.** Method for temperature compensation of measuring signals of a fibre-optic sensor (6),

a) in which, for the purpose of detecting a physical variable, light is guided through an optical sensor fibre (s) to an optical receiving fibre (r),
b) the light in the sensor fibre (s) and in the receiving fibre (r) propagating in two different spatial modes or in two orthogonal polarization states of one spatial mode,
c) an interference pattern of the spatial modes or of the orthogonal polarization states being detected at the end of the receiving fibre (r) by means of two light detectors (D1, D2) which supply on the output side first and second light power signals U1, U2 which are proportional to the received light power.
d) whose difference ($\Delta U$) is supplied to the input of a differential voltage regulator (11) which supplies a control signal U13 on the output side,
e) which acts on a modulator (7) which is operationally connected to the receiving fibre (r), and controls the differential optical phase of the spatial modes or of the orthogonal polarization states of the receiving fibre (r) in such a way that this difference ($\Delta U$) vanishes,
**characterized in that**
f) superimposed on the control signal (U13) is an oscillator signal ($U_{HF}$) of prescribable amplitude, whose frequency (f) is at least so high that a light modulation of frequency (f) effected in the receiving fibre (r) by the oscillator signal ($U_{HF}$) is not compensated by the differential voltage regulator (11),
g) a contrast parameter K is calculated as a function of these first and second light power signals (U1, U2) in accordance with:

$$K = (U1 - U2)/(U1 + U2),$$

h) a signal receiver temperature $T_r$ is measured by means of a temperature detector (21),
i) a sensor temperature $T_s$ is determined as a function of this contrast parameter (K) and a temperature calibration function $E(T_r)$ in accordance with: $T_s = f(K, E(T_r))$, and
j) a temperature-corrected measuring signal M is provided as a function of this sensor temperature $(T_s)$ and the control signal (U13) in accordance with:

$$M = U13 \cdot (1 + \alpha \cdot (T_0 - T_s)),$$

$T_0$ signifying a prescribable calibration temperature of the sensor fibre (s) and $\alpha$ signifying the temperature coefficient of the sensor (6).

**2.** Method according to Claim 1, **characterized in that**

a) the amplitude of the oscillator signal ($U_{HF}$) is held constant, and
b) the frequency (f) of the oscillator signal ($U_{HF}$) is in the frequency band of 50 kHZ - 1 MHz.

**3.** Method according to Claim 1 or 2, **characterized in that** the signal receiver temperature $(T_r)$ is held constant at a prescribable temperature value.

**4.** Method according to one of the preceding claims, **characterized in that**

a) the sensor fibre (s) is a double-mode fibre in which an $LP_{01}$ fundamental mode and an even $LP_{11}$ mode are propagated, and
b) the receiving fibre (r) is a double-mode fibre in which the $LP_{01}$ fundamental mode and the even $LP_{11}$ mode are propagated.

**5.** Method according to one of Claims 1 to 3, **characterized in that**

a) the sensor fibre (s) is a polarimetric fibre in which the two orthogonal polarization states of an $LP_{01}$ fundamental mode are propagated, and
b) the receiving fibre (r) is a double-mode fibre in which the $LP_{01}$ fundamental mode and an even $LP_{11}$ mode are propagated.

**6.** Method according to one of Claims 1 to 3, **characterized in that**

a) the sensor fibre (s) is a polarimetric fibre in which the two orthogonal polarization states of an $LP_{01}$ fundamental mode are propagated, and

b) the receiving fibre (r) is a polarimetric fibre in which the two orthogonal polarization states of the $LP_{01}$ fundamental mode are propagated.

7. Method according to one of the preceding claims, **characterized in that**

a) the contrast parameter (K) is determined as a function of the sensor temperature ($T_s$) and
b) as a function of an accumulated, relative optical path difference

$$\Delta L_r - \Delta L_s$$

where

$$\Delta L_r = l_r \cdot \Delta n_{g,r},$$

$l_r$ being the length of the receiving fibre (r), and $\Delta n_{g,r}$ being the difference between the group index of the two modes, either the $LP_{01}(x')$ mode and the even $LP_{11}(x')$ mode or the $LP_{01}(y')$ mode and the even $LP_{11}(y')$ mode, in the case of a double-mode fibre, depending on polarization in the direction of their optical main axes (x',y') or the $LP_{01}(x')$ mode and the $LP_{01}(y')$ mode, in the case of a polarimetric fibre, and where

$$\Delta L_s = l s \cdot \Delta n_{g,s},$$

$l_s$ being the length of the sensor fibre (s) and $\Delta n_{g,s}$ being the difference between the group indexes of the two modes, either the $LP_{01}(x')$ mode and the even $LP_{11}(x')$ mode or the $LP_{01}(y')$ mode and the even $LP_{11}(y')$ mode, in the case of a double-mode fibre, depending on the polarization in the direction of one of the optical main axes (x',y') or the $LP_{01}(x')$ mode and the $LP_{01}(y')$ mode, in the case of a polarimetric fibre.

8. Method according to Claim 7, **characterized in that** the contrast parameter (K) is additionally determined as a function of the signal receiver temperature ($T_r$).

**Revendications**

1. Procédé pour la compensation de température de signaux de mesure d'un capteur à fibre optique (6),

a) dans lequel la lumière est acheminée vers une fibre optique de réception (r) à travers une fibre optique du capteur(s) pour l'enregistrement d'une grandeur physique,

b) la lumière se propageant dans la fibre du capteur (s) et dans la fibre de réception (r) selon deux modes spatiaux différents ou selon deux états de polarisation orthogonaux d'un mode spatial,

c) un motif d'interférence des modes spatiaux ou des états de polarisation orthogonaux étant détecté à l'extrémité de la fibre de réception (r) au moyen de deux détecteurs de lumière (D1, D2) qui délivrent du côté des sorties un premier et un second signal de puissance de la lumière U1, U2 proportionnels à la puissance de la lumière reçue,

d) leur différence ($\Delta U$) étant délivrée à l'entrée d'un régulateur de tension différentiel (11) qui délivre du côté de la sortie un signal de régulation U13,

e) qui agit sur un modulateur (7) qui est en liaison fonctionnelle avec la fibre de réception (r) et qui régule la phase optique différentielle des modes spatiaux ou des états de polarisation orthogonaux de la fibre de réception (r) de telle sorte que cette différence ($\Delta U$) devienne égale à 0,

caractérisé

f) en ce qu'au signal de régulation (U13) est superposé un signal d'oscillateur ($U_{HF}$) d'amplitude prédéterminable dont la fréquence (f) a une valeur telle qu'une modulation de lumière de fréquence (f) provoquée par le signal d'oscillateur ($U_{HF}$) dans la fibre de réception (r) ne soit pas compensée par le régulateur de tension différentiel (11),

g) en ce qu'on calcule un paramètre de contraste K en fonction de ces premier et second signaux de puissance de lumière (U1, U2) selon :

$$K = (U1 - U2)/(U1 + U2),$$

h) en ce qu'on mesure une température du récepteur de signal $T_r$ avec un détecteur de température (21),

i) en ce qu'on définisse une température du capteur $T_s$ en fonction de ce paramètre de contraste (K) et d'une fonction de calibrage de la température $E(T_r)$ selon : $T_s = f(K, E(T_r))$ et

j) en ce qu'on dispose d'un signal de mesure M corrigé de la température en fonction de la température ($T_s$) de ce capteur et du signal de régulation (U13) selon :

$$M = U13 \cdot (1 + \alpha \cdot (T_0 - T_s))$$

où $T_0$ représente une température de calibrage prédéterminable de la fibre du capteur (s) et $\alpha$ le coefficient de température du capteur (6).

2. Procédé selon la revendication 1, caractérisé

   a) en ce que l'amplitude du signal d'oscillateur ($U_{HF}$) est maintenue constante et
   b) en ce que la fréquence (f) du signal d'oscillateur ($U_{HF}$) se situe dans la plage de fréquence de 50 kHz - 1 MHz.

3. Procédé selon la revendication 1 ou 2, **caractérisé en ce que** la température du récepteur de signal ($T_r$) soit maintenue constante à une valeur de température prédéterminable.

4. Procédé selon l'une des revendications précédentes, caractérisé

   a) en ce que la fibre du capteur (s) est une fibre bimode dans laquelle se propagent un mode fondamental $LP_{01}$ et un mode pair $LP_{11}$, et
   b) en ce que la fibre de réception (r) est une fibre bimode dans laquelle se propagent le mode fondamental $LP_{01}$ et le mode pair $LP_{11}$.

5. Procédé selon une des revendications 1 à 3, caractérisé

   a) en ce que la fibre du capteur (s) est une fibre polarimétrique dans laquelle se propagent les deux états de polarisation orthogonaux d'un mode fondamental $LP_{01}$, et
   b) en ce que la fibre de réception (r) est une fibre bimode dans laquelle se propagent le mode fondamental $LP_{01}$ et un mode pair $LP_{11}$.

6. Procédé selon une des revendications 1 à 3, caractérisé

   a) en ce que la fibre du capteur (s) est une fibre polarimétrique dans laquelle se propagent les deux états de polarisation orthogonaux d'un mode fondamental $LP_{01}$, et
   b) en ce que la fibre de réception (r) est une fibre polarimétrique dans laquelle se propagent les deux états de polarisation orthogonaux du mode fondamental $LP_{01}$.

7. Procédé selon l'une des revendications précédentes, caractérisé

   a) en ce que le paramètre de contraste (K) est déterminé en fonction de la température du capteur ($T_s$), et
   b) en fonction de la différence relative des chemins optiques accumulée

$$\Delta L_r - \Delta L_s,$$

avec

$$\Delta L_r = l_r \cdot \Delta n_{g, r},$$

où $l_r$ est la longueur de la fibre de réception (r) et $\Delta n_{g, r}$ la différence des indices de réfraction de groupe des deux modes,
soit le mode $LP_{01}(x')$ et le mode pair $LP_{11}(x')$,
soit le mode $LP_{01}(y')$ et le mode pair $LP_{11}(y')$
dans le cas d'une fibre bimode, en fonction de la polarisation en direction de leurs axes optiques principaux (x', y')
ou selon le cas le mode $LP_{01}(x')$ et le mode $LP_{01}(y')$
dans le cas d'une fibre polarimétrique, et avec

$$\Delta L_s = l_s \cdot \Delta n_{g,s},$$

où $l_s$ est la longueur de la fibre du capteur (s) et $\Delta n_{g,s}$ la différence des indices de réfraction de groupe des deux modes,
soit le mode $LP_{01}(x')$ et le mode pair $LP_{11}(x')$,
soit le mode $LP_{01}(y')$ et le mode pair $LP_{11}(y')$
dans le cas d'une fibre bimode, en fonction de la polarisation en direction de l'un des axes optiques principaux (x', y')
ou selon le cas le mode $LP_{01}(x')$ et le mode $LP_{01}(y')$
dans le cas d'une fibre polarimétrique.

8. Procédé selon la revendication 7, **caractérisé en ce que** le paramètre de contraste (K) est de plus déterminé en fonction de la température du récepteur de signal ($T_r$).

FIG.1

FIG.2

FIG.3

FIG.4

FIG.5